# EUROPÄISCHE PATENTSCHRIFT

(11) **EP 3 133 184 B1**
(45) Veröffentlichungstag und Bekanntmachung des Hinweises auf die Patenterteilung: **25.11.2020**
(21) Anmeldenummer: 16184261.2
(22) Anmeldetag: 16.08.2016
(51) Int. Cl.: C23C 14/35, C03C 17/245, C03C 17/34, C23C 14/08, C23C 14/10, C23C 14/58, C03C 17/00

(54) **VERFAHREN ZUM AUSBILDEN EINER SCHICHT MIT HOHER LICHTTRANSMISSION UND/ODER NIEDRIGER LICHTREFLEXION**
METHOD OF FORMING A LAYER HAVING HIGH LIGHT TRANSMISSION AND/OR LOW LIGHT REFLECTION
PROCEDE DE FORMATION D'UNE COUCHE A HAUTE TRANSMISSION LUMINEUSE ET/OU A FAIBLE REFLEXION LUMINEUSE

(30) Priorität: 17.08.2015 DE 102015113542
(43) Veröffentlichungstag der Anmeldung: 22.02.2017
(73) Patentinhaber: Fraunhofer-Gesellschaft zur Förderung der angewandten Forschung e.V., 80686 München (DE)
(72) Erfinder: Junghähnel, Manuela, 01324 Dresden (DE); Preußner, Thomas, 01728 Goppeln (DE); Hartung, Ullrich, 01129 Dresden (DE)

(56) Entgegenhaltungen:
- CN-A- 103 451 609
- DE-A1-102004 014 323
- DE-A1-102005 053 262
- DE-A1-102014 100 769
- US-A1- 2014 272 127
- US-A1- 2015 171 261

## Beschreibung

Die Erfindung betrifft ein Verfahren zum Ausbilden einer Schicht auf einem Substrat, welche eine Erhöhung der Lichttransmission und/oder eine Verringerung der Lichtreflexion bewirkt.

Bei einer Vielzahl optischer Anwendungen ist es erforderlich, ein Substrat mit einer Entspiegelungsschicht zu versehen. Eine Entspiegelungsschicht wird oftmals realisiert, indem eine Anzahl von Teilschichten übereinander abgeschieden wird, bei denen sich Teilschichten mit niedrigem Brechungsindex und Teilschichten mit hohem Brechungsindex abwechseln (DE 10 2005 015 631 A1). Das Abscheiden mehrerer Teilschichten erfordert jedoch entweder einen relativ hohen Zeitaufwand, wenn ein Substrat im Mehrfachdurchlauf an zwei Beschichtungsstationen für das Abscheiden der zwei unterschiedlichen Teilschichtarten vorbeigeführt wird oder aber einen erhöhten apparativen Aufwand, wenn das Substrat in einem Durchlauf an einer der Anzahl der Teilschichten entsprechenden Anzahl von Beschichtungsstationen vorbeigeführt wird.

Aus DE 10 2005 020 168 A1 ist ein Verfahren zum Abscheiden einer Entspiegelungsschicht bekannt, bei welchem eine poröse Schicht aus einem Metall- oder einem Metallmischoxid mittels eines Sol-Gel-Verfahrens abgeschieden wird. Die Poren innerhalb der Schicht bewirken, dass auf die Schicht auftreffende Strahlung an den Porengrenzen mit unterschiedlichen Winkeln reflektiert wird, was zu einer Entspiegelung führt. Gleichzeitig bewirken die Poren in der Schicht aber auch eine Verringerung der Transmission, was die Anwendungsvielfalt dieses Verfahrens einschränkt. In US 2014/0272127 A1 wird für eine optisch wirksame Schicht vorgeschlagen, eine Sol-Gel-Matrix abzuscheiden und organische Mikropartikel aus der Sol-Gel-Matrix durch eine Hitzeeinwirkung herauszulösen, wodurch eine poröse und somit raue Oberfläche entsteht. Verfahren zum Abscheiden einer porösen Schicht sind in DE 10 2005 053 262 A1 offenbart. Hierbei wird zunächst eine Mischschicht aus zwei verschiedenen Materialien mit einem Gradienten im Schichtdickenverlauf abgeschieden und nach der Schichtabscheidung ein Material beispielsweise durch Herausdampfen aus der Mischschicht entfernt. Verfahren zum Abscheiden einer Gradientenschicht sind auch aus DE 10 2004 014 323 A1 bekannt.

Eine weitere Alternative zum Reduzieren der Grenzflächenreflexion von Kunststoffsubstraten ist in DE 102 41 708 A1 beschrieben. Bei diesem Verfahren wird eine Brechzahlgradientenschicht an einer Substratoberfläche ausgebildet, indem ein Polymersubstrat mit einem lonenbeschuss beaufschlagt wird. Derartige Verfahren lassen sich jedoch oftmals nicht bei großflächigen Substraten, wie beispielsweise Kunststofffolien, anwenden.

In DE 10 2014 100 769 A1 werden Verfahren zum Herstellen eines reflexionsmindernden Schichtsystems offenbart, bei dem zunächst eine erste Schicht, anschließend eine anorganische, poröse zweite Schicht und abschließend eine organische Deckschicht abgeschieden werden, wobei in der organischen Deckschicht mittels eines Plasmaätzprozesses eine Nanostruktur erzeugt wird.

Verfahren zum Erhöhen der Oberflächenrauigkeit einer TCO-Schicht sind in US 2015/0171261 A1 beschrieben. Hierbei wird zunächst eine raue TCO-Schicht, die beispielsweise aus Zinkoxid bestehen kann, abgeschieden. Anschließend werden die Erhebungen der rauen TCO-Schicht durch nachfolgende Schichtabscheideprozesse erhöht. Damit nur die Erhebungen der rauen TCO-Schicht mit neuem Schichtmaterial bedeckt werden, sind Maskierungsprozesse erforderlich, welche den Aufwand einer solchen Verfahrensweise erhöhen.

Der Erfindung liegt daher das technische Problem zugrunde, ein Verfahren zum Ausbilden einer Schicht mit hoher Lichttransmission und/oder reduzierter Lichtreflexion hoher Bandbreite zu schaffen, mittels dessen die Nachteile aus dem Stand der Technik überwunden werden können. Insbesondere soll es mit dem erfindungsgemäßen Verfahren auch möglich sein, die Schicht auf großflächigen Substraten auszubilden. Die Lösung des technischen Problems ergibt sich durch Gegenstände mit den Merkmalen des Patentanspruchs 1. Weitere vorteilhafte Ausgestaltungen der Erfindung ergeben sich aus den abhängigen Ansprüchen.

Beim erfindungsgemäßen Verfahren wird eine Schicht mit hoher Lichttransmission und/ oder niedriger Lichtreflexion auf einem Substrat ausgebildet, indem die Schicht zunächst als Mischschicht eines Materials A und eines Materials B abgeschieden wird. Dabei wird die Schicht im Schichtdickenverlauf mit einem Gradienten derart ausgebildet, dass das Material B an der Substratoberfläche den geringsten Anteil und an der Schichtoberfläche den höchsten Anteil am Schichtmaterial aufweist. Nach dem Abscheiden der Schicht wird das Material B zumindest teilweise aus der Schicht entfernt. Beim Entfernen des Materials B aus der Schicht ist darauf zu achten, dass die Struktur des Materials A, die sich innerhalb der Gradientenschicht ausgebildet hat, möglichst nicht beschädigt wird. Durch das zumindest teilweise Entfernen des Materials B aus der Gradientenschicht entsteht eine zerklüftete Struktur, welche unmittelbar an der Substratoberfläche das meiste Schichtmaterial aufweist, das zur Schichtoberfläche hin flächenbezogen immer weniger wird.

Eine solche zerklüftete Struktur bewirkt eine verminderte Lichtreflexion und kann gleichzeitig die Lichttransmission bei einem lichttransparenten Substrat erhöhen. Zum Abscheiden der Gradientenschicht können verschiedene Prozesse angewendet werden. Nasschemische Abscheideprozesse sind hierfür ebenso durchführbar wie auch Vakuumbeschichtungsprozesse, von denen beispielsweise Prozesse der chemischen Gasphasenabscheidung (auch Chemical Vapor Deposition oder verkürzt CVD genannt) oder der physikalischen Gasphasenabscheidung (auch Physical Vapor Deposition oder verkürzt PVD genannt) anwendbar sind. Von den PVD-Prozessen sind insbesondere das co-Sputtern oder auch das co-Verdampfen besonders geeignet, weil mit diesen Abscheideprozessen ein kontinuierlich verlaufender Schichtgradient bei einer dynamischen Beschichtung eines Substrates sehr genau einstellbar ist. Alternativ kann beim erfindungsgemäßen Verfahren der Schichtgradient aber auch stufenförmig im Schichtdickenverlauf eingestellt werden.Dies kann beispielsweise realisiert werden, indem verschiedene Teilschichten mit unterschiedlichem Mischungsverhältnis der Materialen A und B übereinander auf einem Substrat abgeschieden werden. Dies kann beispielsweise realisiert werden, indem verschiedene Teilschichten mit unterschiedlichem Mischungsverhältnis der Materialen A und B übereinander auf einem Substrat abgeschieden werden.

Auch beim zumindest teilweisen Entfernen des Materials B aus der Gradientenschicht können unterschiedliche Prozesse angewendet werden. In Abhängigkeit der verwendeten Materialien A und B kann hierfür das chemische Ätzen ebenso geeignet sein, wie auch das Plasmaätzen oder das Verwenden eines Lösungsmittels.

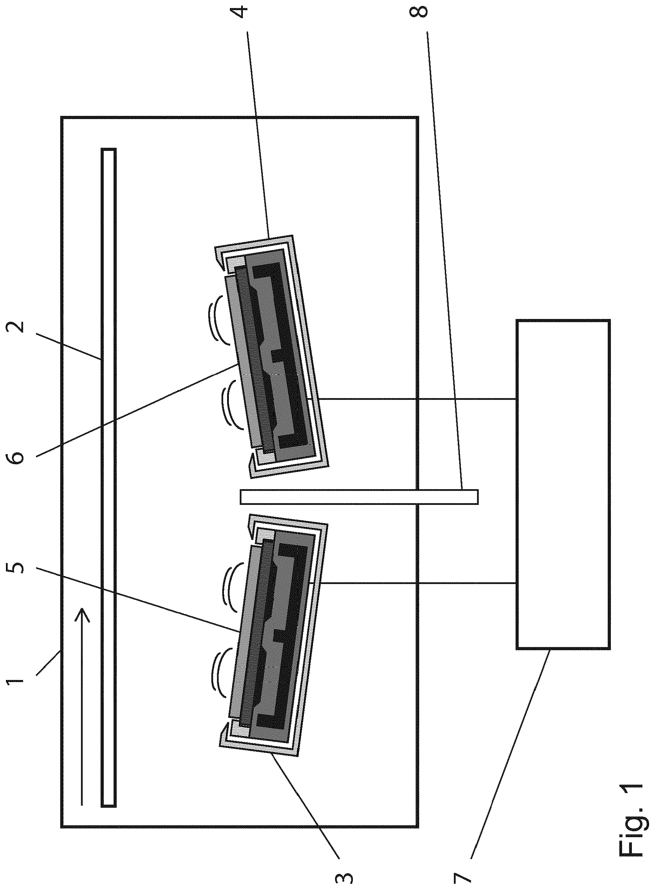

Die vorliegende Erfindung wird nachfolgend anhand eines Ausführungsbeispiels näher erläutert. Die Fig. 1 zeigt eine schematische Darstellung einer Vorrichtung, mittels der eine Gradientenschicht erfindungsgemäß abgeschieden werden kann. Die Vorrichtung umfasst eine Vakuumkammer 1, durch die ein lichttransparentes Substrat 2 aus Glas in Pfeilrichtung hindurchbewegt wird. Beim Durchführen durch die Vakuumkammer 1 wird das Substrat 2 erst über ein Magnetron 3 und anschließend über eine Magnetron 4 hinwegbewegt. Nach dem erfindungsgemäßen Behandeln des Substrates 2 soll dieses eine verminderte Lichtreflexion und eine erhöhte Lichttransmission aufweisen. Es ist vorteilhaft, wenn als Material A ein Material mit einem Brechungsindex ausgewählt wird, der möglichst nahe am Brechungsindex des Substrates liegt. Gleichzeitig besteht hinsichtlich des Materials A immer auch eine Anforderung dahingehend, dass das Material A dem nach der Schichtabscheidung folgenden Prozess des Entfernens des Materials B standhalten muss. Da beim Ausführungsbeispiel das Substrat 2 aus Glas besteht, wurde leitfähig dotiertes Siliziumdioxid, welches einen ähnlichen Brechungsindex wie das Glassubstrat 2 aufweist, als Material A gewählt. Alternativ sind hierfür auch siliziumoxidhaltige Verbindungen geeignet. Als Material B wurde Aluminium-Zinkoxid (AZO) gewählt. Als Material B sind aber beispielsweise auch andere zinkoxidhaltige Verbindungen oder Zinkoxid verwendbar.

Das Magnetron 3 ist im Ausführungsbeispiel mit einem Target 5 aus Siliziumdioxid und das Magnetron 4 mit einem Target 6 aus AZO bestückt. Das Magnetron 3 und das Magnetron 4 sind elektrisch mit einer bipolar pulsenden Stromversorgungseinrichtung 7 verbunden und werden auf diese Weise abwechselnd und gegenläufig als Kathode bzw. Anode einer Magnetronentladung geschaltet. Zum Betreiben der Magnetrons 3 und 4 wird durch einen Einlass 8 das Arbeitsgas Argon in die Vakuumkammer 1 eingelassen. Dabei sind die Magnetrons 3 und 4 derart zueinander ausgerichtet, dass sich die Partikelwolken der von den Targets 5 und 6 abgestäubten Partikel teilweise überlagern, bevor die Partikel auf dem Substrat 2 abgeschieden werden. Dieses co-Sputtern der Targets 5 und 6 mit den teilweise überlagerten Partikelwolken führt zum Abscheiden einer Gradientenschicht auf dem bewegten Substrat 2 derart, dass auf der Oberfläche des Substrats 2 zunächst ausschließlich Siliziumdioxid abgeschieden wird. Mit aufwachsender Schichtdicke weist die Schicht dann auch einen Anteil von AZO auf, der mit zunehmender Schichtdicke kontinuierlich ansteigt und an der Schichtoberfläche schließlich 100 % beträgt. Beim Ausführungsbeispiel wird die Gradientenschicht mit einer Dicke von 1 µm abgeschieden.

Für das erfindungsgemäße Entfernen des AZO aus der abgeschiedenen Gradientenschicht wurde chemisches Ätzen mittels einer 0,5 prozentigen Salzsäurelösung gewählt. Nach wenigen Minuten in einer solchen Salzsäurelösung ist das AZO größtenteils aus der Gradientenschicht entfernt, während die in der Gradientenschicht ausgebildete Struktur des Siliziumdioxid nahezu vollständig erhalten bleibt. Die auf diese Weise erzeugte Restschicht mit einer Dicke von 0,6 µm und mit einer zerklüfteten Schichtstruktur führt zu einem Verbund aus Substrat 2 und darauf abgeschiedener Schicht mit einer höheren Lichttransmission und niedrigerer Lichtreflexion gegenüber dem unbeschichteten Substrat 2.

Es sei ausdrücklich erwähnt, dass die im Ausführungsbeispiel genannten Schichtmaterialien Siliziumdioxid und AZO lediglich Beispielcharakter haben und die Materialpalette für Material A und Material B nicht beschränken. Für das Material B besteht eine Einschränkung lediglich dahingehend, dass es aus einer erfindungsgemäß abgeschiedenen Gradientenschicht mit bekannten Verfahrensschritten zumindest teilweise entfernbar sein muss ohne dabei die Schichtstruktur des in der Gradientenschicht ausgebildeten Materials A wesentlich zu zerstören. Das Material A ist dadurch limitiert, dass es dem Verfahrensschritt des Entfernens des Materials B aus der Gradientenschicht widerstehen muss. Es ist vorteilhaft, wenn das Material A zusätzlich auch noch einen Brechungsindex aufweist, der dem Brechungsindex des Substrates möglichst nahe kommt.

## Patentansprüche

1. Verfahren zum Ausbilden einer Schicht auf einem Substrat (2), welche die Lichttransmission des Substrates (2) erhöht und/oder dessen Lichtreflexion verringert, wobei die Schicht als Mischschicht eines Materials A und eines Materials B abgeschieden wird, wobei die Schicht im Schichtdickenverlauf mit einem Gradienten derart ausgebildet wird, dass das Material B an der Substratoberfläche den geringsten Anteil und an der Schichtoberfläche den höchsten Anteil am Schichtmaterial aufweist, und dass nach dem Abscheiden der Schicht das Material B zumindest teilweise aus der Schicht entfernt wird, **dadurch gekennzeichnet, dass** Zinkoxid oder eine zinkoxidhaltige Verbindung als Material B verwendet wird.

2. Verfahren nach Anspruch 1, **dadurch gekennzeichnet, dass** zum Abscheiden der Schicht ein nasschemischer Abscheideprozess verwendet wird.

3. Verfahren nach Anspruch 1, **dadurch gekennzeichnet, dass** zum Abscheiden der Schicht ein Vakuumabscheideprozess verwendet wird.

4. Verfahren nach Anspruch 3, **dadurch gekennzeichnet, dass** zum Abscheiden der Schicht ein PVD- oder ein CVD-Prozess verwendet wird.

5. Verfahren nach Anspruch 4, **dadurch gekennzeichnet, dass** das Material A und das Material B mittels co-Sputtern auf dem Substrat abgeschieden werden, wobei das Substrat eine Relativbewegung gegenüber der Sputtereinrichtung ausführt.

6. Verfahren nach Anspruch 1, **dadurch gekennzeichnet, dass** zum Entfernen des Materials B aus der Schicht chemisches Ätzen angewendet wird.

7. Verfahren nach Anspruch 6, **dadurch gekennzeichnet, dass** eine Salzsäurelösung zum chemischen Ätzen verwendet wird.

8. Verfahren nach Anspruch 1, **dadurch gekennzeichnet, dass** zum Entfernen des Materials B aus der Schicht Plasmaätzen angewendet wird.

9. Verfahren nach Anspruch 1, **dadurch gekennzeichnet, dass** zum Entfernen des Materials B aus der Schicht ein Lösungsmittel verwendet wird.

10. Verfahren nach Anspruch 1, **dadurch gekennzeichnet, dass** Siliziumoxid oder eine siliziumoxidhaltige Verbindung als Material A verwendet wird.

## Claims

1. Method for forming a layer on a substrate (2), which layer increases the light transmission of the substrate (2) and/or reduces the light reflection thereof, wherein the layer is deposited as a mixed layer of a material A and of a material B, wherein the layer is formed in the layer thickness profile with a gradient such that the material B has the smallest proportion of the layer material at the substrate surface and the highest proportion of the layer material at the layer surface and that, after the deposition of the layer, the material B is removed at least in part from the layer,
**characterized in that**
zinc oxide or a zinc-oxide-containing compound is used as the material B.

2. Method according to Claim 1, **characterized in that** a wet-chemical deposition process is used for the deposition of the layer.

3. Method according to Claim 1, **characterized in that** a vacuum deposition process is used for the deposition of the layer.

4. Method according to Claim 3, **characterized in that** a PVD or a CVD process is used for the deposition of the layer.

5. Method according to Claim 4, **characterized in that** the material A and the material B are deposited on the substrate by means of co-sputtering, wherein the substrate performs a relative movement with respect to the sputtering device.

6. Method according to Claim 1, **characterized in that** chemical etching is used for removing the material B from the layer.

7. Method according to Claim 6, **characterized in that** a hydrochloric acid solution is used for the chemical etching.

8. Method according to Claim 1, **characterized in that** plasma etching is applied to remove the material B from the layer.

9. Method according to Claim 1, **characterized in that** a solvent is used to remove the material B from the layer.

10. Method according to Claim 1, **characterized in that** silicon oxide or a silicon-oxide-containing compound is used as the material A.

## Revendications

1. Procédé de formation, sur un substrat (2), d'une couche qui augmente la transmission de lumière du substrat (2) et/ou qui réduit la réflexion de lumière de celui-ci, la couche étant déposée sous la forme d'une couche mixte formée d'un matériau A et d'un matériau B, la couche étant formée dans l'épaisseur de la couche avec un gradient tel que le matériau B, au niveau du matériau de couche, a le pourcentage le plus faible sur la surface du substrat et le pourcentage le plus élevé sur la surface de la couche, et tel que, après le dépôt de la couche, le matériau B est au moins partiellement retiré de la couche,
**caractérisé en ce que**
de l'oxyde de zinc ou un composé contenant de l'oxyde de zinc est utilisé comme matériau B.

2. Procédé selon la revendication 1, **caractérisé en ce qu'**un procédé de dépôt chimique par voie humide est utilisé pour déposer la couche.

3. Procédé selon la revendication 1, **caractérisé en ce qu'**un procédé de dépôt sous vide est utilisé pour déposer la couche.

4. Procédé selon la revendication 3, **caractérisé en ce qu'**un procédé PVD ou CVD est utilisé pour déposer la couche.

5. Procédé selon la revendication 4, **caractérisé en ce que** le matériau A et le matériau B sont déposés sur le substrat par co-pulvérisation, le substrat effectuant un mouvement relatif par rapport au dispositif de pulvérisation.

6. Procédé selon la revendication 1, **caractérisé en ce que** la gravure chimique est utilisée pour éliminer le matériau B de la couche.

7. Procédé selon la revendication 6, **caractérisé en ce qu'**une solution d'acide chlorhydrique est utilisée pour la gravure chimique.

8. Procédé selon la revendication 1, **caractérisé en ce que** la gravure plasma est utilisée pour éliminer le matériau B de la couche.

9. Procédé selon la revendication 1, **caractérisé en ce qu'**un solvant est utilisé pour éliminer le matériau B de la couche.

10. Procédé selon la revendication 1, **caractérisé en ce que** l'oxyde de silicium ou un composé contenant de l'oxyde de silicium est utilisé comme matériau A.
